# FASCICULE DE BREVET EUROPEEN

(11) **EP 1 357 201 B1**
(45) Date de publication et mention de la délivrance du brevet: **27.03.2019**
(21) Numéro de dépôt: 03290944.2
(22) Date de dépôt: 16.04.2003
(51) Int. Cl.: C23C 14/30, C04B 35/622

(54) **Formation d'un revetement céramique à gradient de composition par dépot physique en phase vapeur sous faisceau d'electrons**
Verfahren zum Herstellen einer keramischen Gradientenbeschichtung mittels Elektronstrahl-PVD
Process to form a composition-gradient ceramic layer by electron-beam PVD

(30) Priorité: 22.04.2002 FR 0204982
(43) Date de publication de la demande: 29.10.2003
(73) Titulaire: Safran Aircraft Engines, 75015 Paris (FR)
(72) Inventeur: Chaput, Christophe, F87410 Le Palais sur Vienne (FR); Delage, Cyrille, 87000 Limoges (FR); Malie, André, 86100 Chatellerault (FR); Porte, Isabelle, 87920 Condat sur Vienne (FR); Saint Ramond, Bertrand, 77300 Fontainbleau (FR)
(74) Mandataire: Laïk, Eric

(56) Documents cités:
- EP-A- 0 799 904
- EP-A- 1 158 061
- WO-A-00/09778
- WO-A-99/63127
- DE-C- 4 302 167
- DE-C- 19 708 509
- US-A- 3 655 430
- US-A- 5 780 171
- US-B1- 6 168 833

## Description

### Arrière-plan de l'invention

L'invention est relative à la formation de revêtements céramiques sur des substrats et notamment à la fabrication de barreaux ou cibles utilisables comme sources pour former de tel revêtement par dépôt physique en phase vapeur sous faisceau d'électrons.

Un domaine particulier d'application de l'invention est la formation de revêtements externes céramiques de barrières thermiques pour des pièces métalliques en superalliages telles que des aubes ou distributeurs de turbines à gaz.

Afin d'optimiser le fonctionnement de turbines à gaz, notamment de turboréacteurs, on cherche à les faire fonctionner aux températures les plus élevées possibles, ce qui permet d'accroître le rendement, de diminuer la consommation spécifique en carburant et de réduire les émissions polluantes (oxydes de carbone, soufre, azote) et les imbrûlés.

Les pièces de turboréacteurs exposées aux températures les plus élevées, notamment aubes et distributeurs de turbines, sont habituellement réalisées en alliages métalliques réfractaires, ou superalliages, à base nickel ou cobalt, et sont munies de revêtements de protection.

Ces revêtements de protection sont généralement des revêtements multicouches formant barrières thermiques et composés d'une partie de revêtement externe en céramique à faible conductivité thermique et d'une partie de revêtement interne métallique protégeant le superalliage contre l'oxydation et la corrosion et favorisant l'adhérence du revêtement céramique externe. La partie de revêtement interne métallique, ou sous-couche de barrière thermique, est habituellement de type aluminiure. Elle peut être aussi de type MCrAIY où le métal M est Ni, Co ou Ni+Co. Un film d'alumine se développe à la surface de la sous-couche, qui favorise l'accrochage du revêtement externe céramique.

Le revêtement externe en céramique est généralement formé par un procédé de dépôt physique en phase vapeur sous faisceau d'électrons. Un tel procédé permet en effet la croissance de revêtement à morphologie colonnaire apte à bien supporter les différences de contraintes thermomécaniques dans les différentes couches de la barrière thermique.

Ce procédé de dépôt, connu sous la dénomination EB-PVD ("Electron Beam-Physical Vapour Déposition" pour dépôt physique en phase vapeur sous faisceau d'électrons) consiste à introduire un ou plusieurs substrats dans une chambre de dépôt dans laquelle a été placé un barreau, ou cible, formant une source dont la composition correspond à celle du revêtement céramique à former. Dans l'application particulière envisagée, les substrats sont les pièces métalliques en superalliage munies d'une sous-couche métallique de barrière thermique.

Le barreau est placé verticalement et sa surface supérieure est balayée par un faisceau d'électrons qui provoque la fusion superficielle du matériau du barreau. La chambre est sous vide, ce qui permet la formation d'un nuage provenant de l'évaporation du matériau du barreau. Le matériau évaporé se dépose par condensation sur les substrats entraînés en rotation face au nuage d'évaporation. Le processus est poursuivi jusqu'à obtention de l'épaisseur désirée de revêtement, par consommation progressive du barreau.

Le matériau le plus couramment utilisé pour des revêtements céramiques de barrières thermiques pour pièces de turbine à gaz en superalliage est la zircone (ZrO₂) stabilisée par l'oxyde d'yttrium (Y₂O₃) ou zircone yttriée.

Les performances exigées aujourd'hui, et encore plus à l'avenir, de ces revêtements céramiques sont telles qu'elles ne peuvent plus être remplies par un revêtement formé d'une couche d'un même matériau céramique.

C'est pourquoi il a été proposé de réaliser des revêtements céramiques multi-couches avec des couches de compositions différentes assurant des fonctions particulières.

Ainsi, le brevet US 5 683 825 décrit un revêtement céramique avec une couche de matériau résistant à l'érosion en alumine ou carbure de silicium déposée par dépôt physique ou chimique en phase vapeur sur une couche de zircone yttriée colonnaire.

La demande de brevet WO 00/09778 décrit un revêtement céramique avec une couche supérieure composée de zircone stabilisée à l'oxyde de scandium ou d'hafnium possédant une stabilisé thermique élevée aux hautes températures et une couche inférieure de zircone yttriée permettant l'accrochage avec la sous-couche métallique.

Dès lors qu'elle implique la réalisation de plusieurs cycles de dépôt utilisant des sources différentes, la formation de revêtements céramiques multicouches entraîne des coûts très importants.

La réalisation de revêtements céramiques en une phase continue a été proposée, mais au prix d'une complexification du procédé de dépôt physique.

Ainsi, dans la demande de brevet EP 0 705 912, il est proposé de réduire la conductivité thermique en alternant des dépôts par EB-PVD et PAPVD ("Plasma Assisted Physical Vapour Déposition", ou dépôt physique en phase vapeur assisté par plasma).

Dans la demande WO 96/11288, la conductivité thermique est diminuée en alternant des dépôts de couches nanométriques de zircone yttriée et d'alumine, les dépôts étant formés par EB-PVD en utilisant deux sources distinctes.

Le brevet US 5 350 599 propose de réaliser une structure multicouche en modifiant la morphologie des couches consécutives d'une même composition par variation de la rotation des substrats à revêtir.

Quant au brevet US 5 792 521, il propose de réaliser des dépôts multicouches par balayage de sources différentes formées par des cibles positionnées de manière spécifique dans la chambre de dépôt.

Il a été encore proposé de réaliser un revêtement de protection présentant un gradient de composition dans son épaisseur par EB-PVD, au moyen d'un barreau ou source contenant les différents constituants des couches du revêtement.

Ainsi, le brevet US 6 287 644 décrit un processus au cours duquel différents constituants du barreau sont évaporés successivement dans l'ordre de pression de vapeur décroissante. Un revêtement de protection est formé avec une composition variant de façon continue d'une sous-couche métallique déposée sur une pièce en superalliage jusqu'à un revêtement externe céramique.

Quant à la demande de brevet EP 1 096 037, elle décrit l'utilisation comme barreau d'un lingot composite formé par un bloc de zircone yttriée dans lequel sont inclus des inserts en métal, ou en mélange métal-céramique, ou en céramique, chaque insert occupant une fraction de la section transversale du lingot.

Avec ces deux derniers procédés, la surface balayée par le faisceau d'électrons contient toujours des matériaux destinés à différentes couches du revêtement à former. En dépit de l'existence de tensions de vapeur différentes, il est en pratique impossible de contrôler le procédé de manière à obtenir une composition précise prédéterminée dans chaque couche du revêtement formé.

En outre, la réalisation d'un lingot avec des inserts de différentes formes, comme dans EP 1 096 037, est délicate.

Un procédé de dépôt physique en phase vapeur utilisant un lingot formé de poudres céramiques de granulométries différentes, non frittées, est décrit dans le document US 6 168 833.

La possibilité de faire varier la composition du lingot afin de réaliser un revêtement à gradient de composition est évoquée mais sans autre indication.

Enfin, on connaît du brevet EP 1 158 061 un procédé de formation d'un matériau stratifié formé de couches de poudres de composition différentes qui sont comprimées dans un moule et frittées. Le matériau est utilisé pour réaliser un barreau parallélépipédique ou cylindrique par découpe à travers les strates superposées de matériau. Le barreau est soumis à un traitement thermique pour former, par fusion, une fibre à gradient de composition.

### Objets et résumé de l'invention

La présente invention a pour but de permettre la réalisation d'un revêtement céramique à gradient de composition dans son épaisseur par un procédé EP-PVD, en un seul cycle continu de dépôt, sans complication particulière du procédé ou de l'installation de dépôt et avec un contrôle précis de la composition des différentes couches du revêtement.

Selon un premier objet, l'invention vise un procédé comprenant les étapes de :
- mise en place dans une chambre d'une cible composite en forme de barreau formé de poudres céramiques et présentant une composition non uniforme en direction longitudinale,
- introduction dans la chambre d'au moins un substrat sur lequel un revêtement céramique ayant un gradient de composition doit être formé, et
- balayage d'une face supérieure du barreau par un faisceau d'électrons afin de provoquer la fusion du matériau du barreau à sa face supérieure et la formation d'un nuage de vapeur dans la chambre sous pression réduite,
procédé selon lequel on utilise un barreau présentant une pluralité de couches superposées de compositions différentes, la composition étant, au sein de chaque couche, uniforme dans toute la section transversale du barreau, et chaque couche comportant de la zircone et au moins un oxyde choisi parmi des oxydes de nickel, de cobalt, de fer, d'yttrium, d'hafnium, de cérium, de lanthane, de tantale, de niobium, de scandium, de samarium, de gadolinium, de dysprosium, d'ytterbium, et d'aluminium de sorte que le revêtement céramique formé sur le substrat par consommation progressive du barreau reflète la variation de composition du barreau.

La composition du barreau peut varier d'une couche à l'autre par palier(s) ou de façon progressive.

Chaque couche du barreau comprend de la zircone, avantageusement de la zircone stabilisée. Un ou plusieurs composants autres que la zircone stabilisée sont ajoutés, afin de conférer au revêtement céramique une ou plusieurs fonctions particulières.

La fonction d'accrochage du revêtement sur le substrat peut être favorisée par l'ajout d'oxyde d'yttrium à la zircone, une ou plusieurs couches du barreau au moins dans sa partie consommée en premier comprenant alors de la zircone yttriée.

La fonction de diminution de conductivité thermique peut être assurée par l'ajout d'au moins un composant choisi notamment parmi des oxydes de nickel, de cobalt, de fer, d'yttrium, d'hafnium, de cérium, de lanthane, de tantale, de niobium, de scandium, de samarium, de gadolinium, de dysprosium et d'ytterbium.

La fonction de résistance à l'abrasion dans les couches superficielles peut être favorisée par la présence d'alumine.

La fonction de stabilité thermique peut être renforcée par la présence d'au moins un composant choisi parmi notamment des oxydes cités plus haut pour la diminution de la conductivité thermique, ainsi que d'un composé choisi parmi des composés à structure pyrochlore, des composés du type Garnet et des composés à structure magnétoplumbite.

Le gradient de composition entre deux couches au sein du barreau peut être obtenu par variation des proportions des mêmes composants constitutifs des deux couches ou en réalisant les deux couches avec des composants différents.

La présente invention a aussi pour objet de fournir un barreau apte à former une cible ou source pour la mise en oeuvre du procédé, ainsi qu'un procédé de fabrication d'un tel barreau.

### Brève description des dessins

L'invention sera mieux comprise à la lecture de la description ci-après à titre indicatif, mais non limitatif, en référence aux dessins annexés, sur lesquels :
- la figure 1 est une vue très schématique d'une chambre de dépôt pour la formation de revêtements sur des substrats par le procédé EB-PVD ;
- la figure 2 est une vue schématique d'un mode de réalisation d'un barreau composite selon un mode de mise en oeuvre de l'invention ;
- la figure 3 est une vue schématique partielle en coupe montrant l'assemblage de deux galets constitutifs d'un barreau composite ;
- la figure 4 est une vue schématique d'un mode de réalisation d'un barreau composite selon un autre mode de mise en oeuvre de l'invention ;
- la figure 5 est une vue très schématique montrant une installation pour la fabrication d'un barreau composite conforme à l'invention ; et
- la figure 6 est une vue très schématique montrant une autre installation pour la fabrication d'un barreau composite conforme à l'invention.

### Description détaillée de modes de réalisation

Dans la description qui suit, il sera fait référence au domaine particulier d'application de l'invention qui consiste dans la réalisation de revêtements externes céramiques sur des sous-couches de barrières thermiques pour des pièces de parties chaudes de turbines à gaz, telles que des aubes mobiles ou distributeurs en superalliage pour turboréacteurs. L'invention est toutefois applicable à la réalisation de revêtements céramiques à gradient de composition sur des substrats autres que des pièces en superalliage munies d'une sous-couche métallique de barrière thermique.

Il existe différents procédés pour former une sous-couche métallique de barrière thermique sur une pièce en superalliage, notamment pour former une sous-couche en un matériau de type aluminiure. Ces procédés, qui n'entrent pas dans le cadre de la présente invention, ne seront pas décrits en détail. La technique la plus couramment utilisée est l'aluminisation par cémentation.

Il est bien connu aussi d'introduire dans la sous-couche métallique de type aluminiure un élément actif qui renforce la fonction de barrière de diffusion vis-à-vis d'éléments du superalliage métallique. En effet, de tels éléments seraient susceptibles d'affecter l'intégrité et la persistance du film d'alumine qui se forme à la surface de la sous-couche et favorise l'accrochage du revêtement céramique. Ces éléments actifs sont notamment le zirconium, l'hafnium, l'yttrium et les lanthanides. Le ou les éléments actifs peuvent être alliés ou associés séparément avec un ou plusieurs constituants de la sous-couche métallique pour être déposés ensembles par un processus de dépôt physique en phase vapeur, d'une composition de type MCrAIY où M est Ni et/ou Co et/ou Fe, par électrophorèse, ou par aluminisation, le ou les éléments actifs étant incorporés dans le cément.

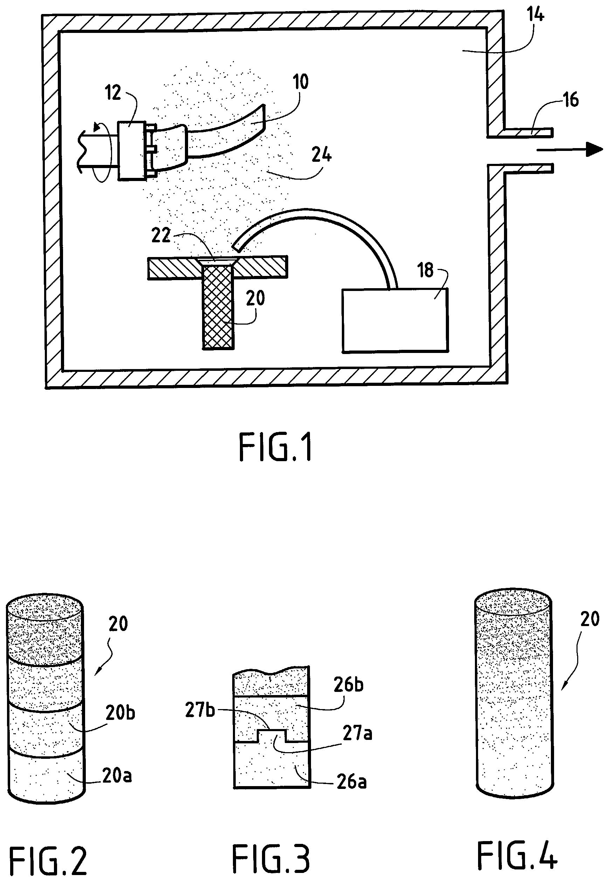

Afin de former le revêtement céramique, un ou plusieurs substrats constitués de pièces en superalliage munies d'une sous-couche métallique de barrière thermique sont introduits dans une chambre de dépôt par EB-PVD telle que montrée très schématiquement par la figure 1.

Le ou chaque substrat 10 (un seul est représenté) est monté sur un support rotatif 12 à l'intérieur de la chambre 14. Celle-ci est reliée à une source de vide (non représentée) par une conduite 16.

Un générateur 18 situé dans la chambre produit un faisceau d'électrons qui est dirigé vers la face supérieure d'une cible, ou source 20. Celle-ci est sous forme d'un barreau cylindrique disposé verticalement. La face supérieure du barreau 20 affleure dans une cuvette 22.

Sous l'effet du balayage par le faisceau d'électrons, la partie supérieure du barreau 20 entre en fusion et, en raison du vide régnant dans la chambre, il se forme un nuage de vapeur 24. Celui-ci se condense sur le substrat 10 qui est entraîné en rotation pour former un dépôt uniforme. Le matériau déposé est déterminé par la composition du barreau 20.

Une chambre de dépôt par EB-PVD telle que décrite succinctement ci-avant est bien connue en soi de sorte qu'une description plus détaillée n'est pas nécessaire.

Selon l'invention, on forme sur le substrat un dépôt céramique à gradient de composition par utilisation d'un barreau composite qui reproduit, sur sa longueur, la composition du revêtement à former.

Comme indiqué plus haut, un revêtement externe céramique pour une barrière thermique de pièce de turbine à gaz en superalliage est formé habituellement de zircone, de préférence de zircone stabilisée à l'oxyde d'yttrium qui favorise l'accrochage sur la sous-couche métallique. Un ou plusieurs autres composants, généralement mais non nécessairement sous forme d'oxydes, peuvent être introduits à différents niveaux du revêtement afin de conférer des propriétés particulières à celui-ci, ou de renforcer ses propriétés.

Ainsi, la conductivité thermique du revêtement peut être abaissée par introduction d'au moins un composant choisi notamment parmi des oxydes de nickel, de cobalt, de fer, d'yttrium, d'hafnium, de cérium, de lanthane, de tantale, de niobium, de scandium, de samarium, de gadolinium, de dysprosium et d'ytterbium. Le ou les composants (autres qu'yttrium) sont de préférence introduits dans une ou plusieurs couches du revêtement autres que la ou les couches inférieures afin de ne pas affecter l'accrochage sur la sous-couche métallique.

La résistance du revêtement à l'abrasion peut être améliorée par introduction d'alumine dans la ou les couches supérieures.

La stabilité thermique du revêtement peut être renforcée par ajout dans une ou plusieurs couches, d'au moins un composé choisi parmi des composés à structure pyrochlore, des composés de type Garnet (Y₃Al₅O₁₂), et des composés à structure magnétoplumbite (LaMgAl₁₁O₁₉).

De préférence, le revêtement reste majoritairement formé de zircone yttriée dans toutes ses couches. Le ou les composants additionnels sont de préférence présents éventuellement dans chaque couche du revêtement à concurrence, au maximum, de 20% en poids.

Le gradient de composition du revêtement peut résulter d'une variation en proportion de ses constituants d'une couche à l'autre, ces constituants restant les mêmes, et/ou d'une variation de la composition d'une couche à l'autre.

Cette variation d'une couche à l'autre peut être réalisée par palier(s). Comme montré très schématiquement par la figure 2, le barreau 20 comprend alors un nombre fini de couches 20a, 20b,... différentes nettement différenciées. Ces couches peuvent avoir des épaisseurs différentes.

Le barreau 20 peut être réalisé en une seule pièce ou, comme montré par la figure 3 en plusieurs pièces ou galets superposés 26a, 26b,... de compositions différentes. Les galets peuvent être en forme de disques simplement superposés, ou présenter des reliefs complémentaires 27a, 27b tels que plots et évidements ou nervures et rainures favorisant leur assemblage et assurant un meilleur maintien du barreau.

En variante, la variation de composition du barreau peut être continue comme montré schématiquement par la figure 4, le barreau 20 étant alors formé d'une quasi-infinité de couches.

Quel que soit le mode de réalisation, le barreau 20 présente au sein de chaque couche, une composition uniforme dans toute sa section transversale.

Le revêtement formé sur le substrat reproduit, au fur et à mesure de la consommation du barreau, le gradient de composition de celui-ci. Du fait que chaque couche du barreau présente une composition homogène, la composition du bain formé à la surface du barreau est homogène et correspond à celle de la couche affleurante. De la sorte, la composition de chaque couche du revêtement formé peut être précisément contrôlée, et le gradient de composition du revêtement reflète celui du barreau.

Le barreau, ou chaque couche ou galet qui le constitue, est réalisé avantageusement par mélange, compression et frittage de poudres céramiques.

Selon un premier mode de réalisation, convenant plus particulièrement pour un barreau dont la composition varie par paliers, les poudres céramiques constituant chaque couche sont mélangées séparément.

Les poudres sont mélangées en milieu liquide, par exemple dans de l'eau ou dans un solvant organique. Un liant organique peut être ajouté dans cette barbotine afin de faciliter le pressage ultérieur des poudres. Les mélanges de poudres additionnés éventuellement de liant sont ensuite séchés.

Dans le cas du mode de réalisation de la figure 2, avec un barreau réalisé en une seule pièce, les compositions ainsi préparées pour les différentes couches sont introduites dans l'ordre voulu dans un moule ayant la forme du barreau à réaliser.

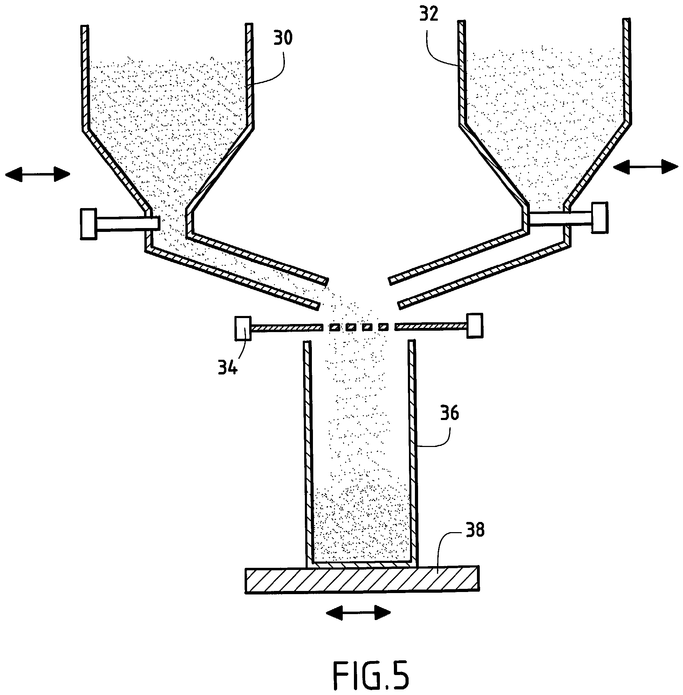

Comme le montre la figure 5, ces compositions peuvent être stockées dans des distributeurs vibrants respectifs 30, 32 (deux seulement sont représentés). Les sorties des distributeurs sont ouvertes séquentiellement dans l'ordre voulu. Les poudres passent à travers une grille ou tamis 34 et sont recueillies dans le moule 36 porté par une table vibrante 38. La quantité de poudres extraite de chaque distributeur correspond à l'épaisseur désirée pour la couche correspondante du barreau à réaliser.

Après introduction de différents mélanges de poudres dans le moule, une compression est réalisée par pressage isostatique à froid. La pression de composition appliquée est de préférence comprise entre 5 MPa et 150 MPa. Une cuisson est ensuite réalisée dans un four en élevant la température jusqu'à un palier maximum compris de préférence entre 800°C et 1 500°C, avec contrôle de la vitesse de montée en température pour éliminer les produits organiques éventuellement présents sans affecter la cohésion du barreau. On obtient ainsi un barreau en une seule pièce à couches séparées et composition variant par paliers.

Dans le cas du mode de réalisation de la figure 3, chaque galet est réalisé séparément par moulage du mélange de poudres approprié, composition par pressage isostatique à froid et cuisson dans des conditions similaires à celles décrites ci-avant.

Dans le cas du mode de réalisation de la figure 4, on prépare séparément différents mélanges de poudres, l'un comprenant de la zircone stabilisée, par exemple de la zircone yttriée et chacun des autres comprenant la même zircone stabilisée additionnée d'un composant supplémentaire respectif devant être introduit à un ou plusieurs niveaux du barreau. Le pourcentage en masse du composant supplémentaire additionné à la zircone yttriée dans chaque mélange correspond au maximum devant être présent dans le barreau.

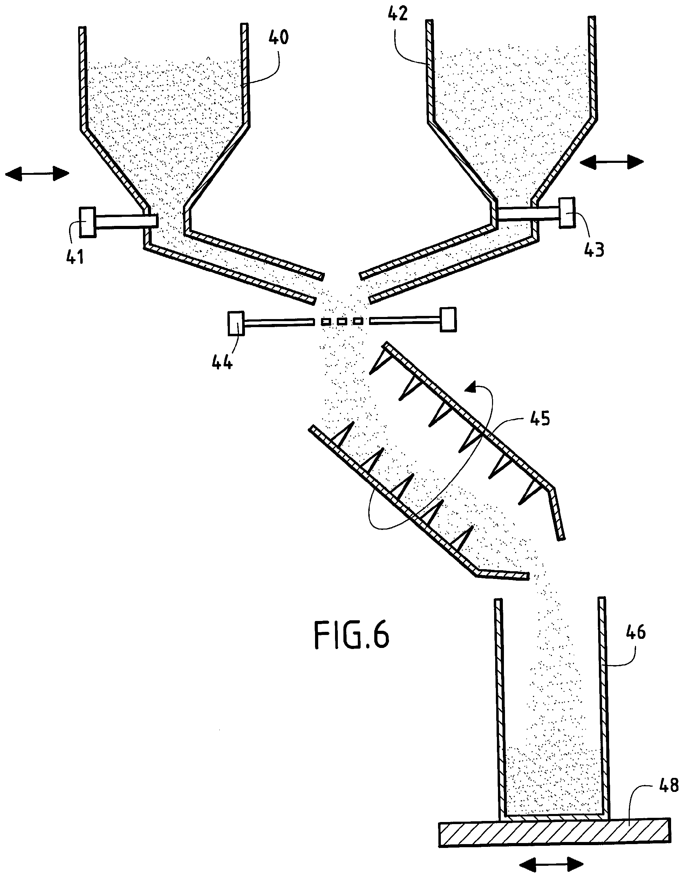

Les différents mélanges sont introduits dans des distributeurs vibrants respectifs 40, 42 dont deux seulement sont représentés sur la figure 6. Le débit de sortie de chaque distributeur est réglé par l'amplitude des oscillations qui lui sont appliquées et par ajustement de la section de sortie 41, 43.

Selon la composition désirée à un niveau donné du barreau, des mélanges de poudres sont extraits d'un seul distributeur ou, simultanément, de plusieurs distributeurs, en réglant le débit de sortie.

Les poudres extraites passent à travers une grille ou tamis 44 et sont acheminées par un mélangeur 45 à un moule 46 supporté par une table vibrante 48.

Le mélangeur 45 assure l'homogénéisation des mélanges de poudres provenant éventuellement de plusieurs distributeurs. On pourra utiliser un mélangeur rotatif à ailettes tel que représenté. D'autres types de mélangeurs de poudres sont utilisables, par exemple des mélangeurs vibrants.

Une transition sans palier de la composition du barreau d'une couche à l'autre peut ainsi être réalisée en augmentant progressivement le débit d'un ou plusieurs distributeur(s) et en réduisant progressivement le débit d'un ou plusieurs autres distributeur(s).

### Exemple 1

Un barreau formé de deux couches distinctes est réalisé au moyen d'une installation telle que celle de la figure 5.

Dans un premier distributeur, on introduit un mélange de poudres réalisé comme suit :
- mélange de 93 g de poudre de zircone ZrO₂ et de 7 g de poudre d'oxyde d'yttrium Y₂O₃ sous forme de granules de dimension environ égale à 150 µm, le mélange étant réalisé en milieu aqueux avec un liant organique;
- séchage du mélange.

Dans un deuxième distributeur, on introduit un mélange de poudres réalisé comme suit :
- mélange de 93 g de poudre de zircone ZrO₂, de 7 g de poudre d'oxyde d'yttrium Y₂O₃ et de 5,26 g de poudre d'oxyde de nickel NiO sous forme de granules de dimension environ égale à 150 µm, le mélange étant réalisé en milieu aqueux avec un liant organique,
- séchage du mélange.

Dans un moule cylindrique à section circulaire de 50 mm de diamètre et de 150 mm de hauteur, on introduit d'abord du mélange de poudres contenu dans le premier distributeur, jusqu'à atteindre 75 mm de hauteur, puis on complète le remplissage du moule avec du mélange de poudres issu du deuxième distributeur.

Les poudres contenues dans le moule sont compactées par pressage isostatique à froid sous 60 MPa puis cuites à 1200°C pendant 60 minutes.

Le barreau obtenu est démoulé et peut être utilisé en l'état, en étant consommé à partir de la face comprenant seulement ZrO₂ + Y₂O₃, pour former un revêtement céramique ayant une couche interne en zircone yttriée accrochée sur la sous-couche métallique de barrière thermique et une couche externe en zircone yttriée modifiée par ajout de NiO diminuant la conductivité thermique et favorisant donc l'établissement d'un gradient de température plus élevé à travers la barrière thermique.

Bien entendu, le nombre de couches distinctes du barreau pourrait être supérieur à 2, par exemple en introduisant une ou plusieurs couches intermédiaires dans lesquelles de la poudre de NiO est introduite, mais dans une proportion intermédiaire entre 0 et celle contenue dans la couche supérieure.

### Exemple 2

Un barreau comprenant une composition variant sans palier est réalisé au moyen de l'installation de la figure 6 en introduisant respectivement dans un premier et un deuxième distributeur des mélanges de poudres tels que ceux de l'exemple 1, à savoir ZrO₂ + 7% Y₂O₃ et ZrO₂ + 7 % Y₂O₃ + 5 % NiO. Le remplissage d'un moule identique à celui de l'exemple 1 est réalisé comme suit :
- 1^{er} distributeur réglé au débit maximum pendant une durée suffisante pour obtenir une hauteur de poudres dans le moule d'environ 50 mm, le 2^{ème} distributeur étant fermé,
- fermeture progressive du 1^{er} distributeur et ouverture progressive du 2^{ème} distributeur pour obtenir un gradient de composition continu sur une hauteur d'environ 60 mm dans le moule,
- ouverture totale du 2^{ème} distributeur, le 1^{er} distributeur étant fermé, jusqu'au remplissage complet du moule.

Le compactage des poudres dans le moule est réalisé par pressage isostatique à froid sous 60 MPa et les poudres sont ensuite cuites à 1230°C pendant 60 minutes.

On obtient, après démoulage, un barreau dont la composition varie progressivement entre une couche formée de ZrO₂ + 7 % Y₂O₃ et une couche formée de ZrO₂ + 7 % Y₂O₃ + 5 % NiO. Le barreau est utilisé en étant consommé à partir de la couche formée de ZrO₂ + 7 % Y₂O₃ pour former un revêtement céramique à gradient de composition progressif ayant une conductivité thermique abaissée dans la partie extérieure.

## Revendications

1. Procédé de formation d'un revêtement céramique sur un substrat par dépôt physique en phase vapeur sous faisceau d'électrons, comprenant les étapes de :
- mise en place dans une chambre d'une cible composite en forme de barreau formé de poudres céramiques et présentant une composition non uniforme en direction longitudinale,
- introduction dans la chambre d'au moins un substrat sur lequel un revêtement céramique ayant un gradient de composition doit être formé, et
- balayage d'une face supérieure du barreau par un faisceau d'électrons afin de provoquer la fusion du matériau du barreau à sa face supérieure et la formation d'un nuage de vapeur dans la chambre sous pression réduite,
**caractérisé en ce que** :
- on utilise un barreau présentant une pluralité de couches superposées de compositions différentes, la composition étant, au sein de chaque couche, uniforme dans toute la section transversale du barreau, et chaque couche comportant de la zircone et au moins un oxyde choisi parmi des oxydes de nickel, de cobalt, de fer, d'yttrium, d'hafnium, de cérium, de lanthane, de tantale, de niobium, de scandium, de samarium, de gadolinium, de dysprosium, d'ytterbium et d'aluminium,
- de sorte que le revêtement céramique formé sur le substrat par consommation progressive du barreau reflète la variation de composition du barreau.

2. Procédé selon la revendication 1, **caractérisé en ce que** l'on utilise un barreau dont la composition varie de façon sensiblement continue d'une couche à une autre.

3. Procédé selon la revendication 1, **caractérisé en ce que** l'on utilise un barreau dont la composition varie par palier d'une couche à une autre.

4. Procédé selon la revendication 3, **caractérisé en ce que** le barreau est formé en superposant des galets de compositions différentes.

5. Procédé selon l'une quelconque des revendications 1 à 4, pour la formation d'un revêtement céramique sur un substrat constitué par une pièce de turbine à gaz en superalliage munie d'une sous-couche métallique de barrière thermique.

6. Procédé selon l'une quelconque des revendications 1 à 5, **caractérisé en ce que** l'on utilise un barreau dont au moins une couche comporte en outre un composé choisi parmi des composés de type pyrochlore, des composés de type Garnet et des composés à structure magnétoplumbite.

7. Barreau formé d'une pluralité de couches différentes pour la mise en oeuvre du procédé selon l'une quelconque des revendications 1 à 6, **caractérisé en ce que** chaque couche a une composition uniforme dans toute la section transversale du barreau et comporte de la zircone et au moins un oxyde choisi par des oxydes de nickel, de cobalt, de fer, d'yttrium, d'hafnium, de cérium, de lanthane, de tantale, de niobium, de scandium, de samarium, de gadolinium, de dysprosium, d'ytterbium et d'aluminium.

8. Barreau selon la revendication 7, caractérisé en qu'au moins une couche du barreau comporte en outre un composé choisi parmi des composés de type pyrochlore, des composés de type Garnet et des composés à structure magnétoplumbite.

9. Barreau selon l'une quelconque des revendications 7 et 8, **caractérisé en ce qu'**il est formé de poudres compactées.

10. Barreau selon l'une quelconque des revendications 7 à 9, **caractérisé en ce qu'**il est réalisé en une seule pièce avec des couches superposées distinctes.

11. Barreau selon l'une quelconque des revendication 7 à 9, **caractérisé en ce que** sa composition varie progressivement dans sa direction longitudinale.

12. Barreau selon l'une quelconque des revendications 7 à 9, **caractérisé en ce qu'**il est formé par superposition de galets de compositions différentes.

13. Barreau selon la revendication 12, **caractérisé en ce que** les galets présentent des reliefs d'accrochage mutuel.

14. Procédé de fabrication d'un barreau selon l'une quelconque des revendications 7 à 11, **caractérisé en ce qu'**il comprend les étapes consistant à :
- préparer un premier mélange de poudres ayant une première composition,
- préparer au moins un deuxième mélange de poudres ayant une deuxième composition différente de la première,
- introduire le premier mélange de poudres puis le deuxième mélange de poudres dans un moule,
- compacter les poudres dans le moule, et
- réaliser une cuisson des poudres compactées.

15. Procédé selon la revendication 14, **caractérisé en ce que** l'on prépare différents mélanges de poudres correspondant à différentes compositions souhaitées des couches du barreau, et on introduit successivement les différents mélanges dans le moule.

16. Procédé selon la revendication 14, **caractérisé en ce que** l'on prépare au moins deux mélanges de poudres, un comprenant une poudre de zircone et une poudre de stabilisant de la zircone et l'autre comprenant une poudre de zircone, une poudre de stabilisant de la zircone et une poudre de composant additionnel, on introduit dans le moule un premier mélange de poudres, puis simultanément le premier mélange de poudres et au moins un second mélange de poudres en diminuant progressivement le débit du premier mélange et en augmentant progressivement le débit du deuxième mélange, et ensuite le deuxième mélange de poudres après interruption de l'introduction du premier.

17. Procédé selon la revendication 16, **caractérisé en ce que** les mélanges de poudres sont stockés dans des distributeurs respectifs et, lors de leur introduction simultanée, sont mélangés par passage dans un mélangeur afin d'être introduits dans le moule.

18. Procédé selon l'une quelconque des revendications 14 à 17, **caractérisé en ce que** chaque mélange de poudres est réalisé en milieu liquide.

19. Procédé selon la revendication 18, **caractérisé en ce qu'**un liant organique est ajouté au milieu liquide.

## Patentansprüche

1. Verfahren zum Ausbilden einer Keramikbeschichtung auf einem Substrat durch physikalische Abscheidung aus der Dampfphase mittels Elektronenstrahl, umfassend die Schritte des:
- Anordnens eines stabförmigen Verbundtargets, welches aus Keramikpulvern besteht und eine ungleichmäßige Zusammensetzung in Längsrichtung aufweist, in einer Kammer,
- Einbringens wenigstens eines Substrats, auf dem eine Keramikbeschichtung mit einem Zusammensetzungsgradienten ausgebildet werden soll, in die Kammer, und
- Abtastens einer Oberseite des Stabs mit einem Elektronenstrahl, um das Schmelzen des Materials des Stabs an seiner Oberseite und die Bildung einer Dampfwolke in der Kammer unter reduziertem Druck zu bewirken,
**dadurch gekennzeichnet, dass**:
- ein Stab verwendet wird, der eine Vielzahl von übereinander angeordneten Schichten unterschiedlicher Zusammensetzungen aufweist, wobei die Zusammensetzung innerhalb einer jeden Schicht im gesamten Querschnitt des Stabs gleichmäßig ist, und wobei jede Schicht Zirkonoxid und wenigstens ein Oxid, das aus Nickel-, Cobalt-, Eisen-, Yttrium-, Hafnium-, Cer-, Lanthan-, Tantal-, Niob-, Scandium-, Samarium-, Gadolinium-, Dysprosium-, Ytterbium- und Aluminiumoxiden ausgewählt ist, umfasst,
- so dass die Keramikbeschichtung, die auf dem Substrat durch fortschreitenden Verbrauch des Stabs gebildet wird, die Zusammensetzungsänderung des Stabs widerspiegelt.

2. Verfahren nach Anspruch 1, **dadurch gekennzeichnet, dass** ein Stab verwendet wird, dessen Zusammensetzung von einer Schicht zur anderen im Wesentlichen kontinuierlich variiert.

3. Verfahren nach Anspruch 1, **dadurch gekennzeichnet, dass** ein Stab verwendet wird, dessen Zusammensetzung von einer Schicht zur anderen stufenweise variiert.

4. Verfahren nach Anspruch 3, **dadurch gekennzeichnet, dass** der Stab dadurch gebildet wird, dass Rollen unterschiedlicher Zusammensetzungen übereinander angeordnet werden.

5. Verfahren nach einem der Ansprüche 1 bis 4, zum Ausbilden einer Keramikbeschichtung auf einem Substrat, das durch ein Gasturbinenteil aus Superlegierung, welches mit einer metallischen Wärmesperrenunterschicht versehen ist, gebildet ist.

6. Verfahren nach einem der Ansprüche 1 bis 5, **dadurch gekennzeichnet, dass** ein Stab verwendet wird, bei dem wenigstens eine Schicht ferner eine Verbindung enthält, die aus Verbindungen des Pyrochlor-Typs, Verbindungen des Granat-Typs und Verbindungen mit Magnetoplumbit-Struktur ausgewählt ist.

7. Stab, der von einer Vielzahl von unterschiedlichen Schichten gebildet ist, für die Durchführung des Verfahrens nach einem der Ansprüche 1 bis 6, **dadurch gekennzeichnet, dass** jede Schicht im gesamten Querschnitt des Stabs eine gleichmäßige Zusammensetzung aufweist und Zirkonoxid sowie wenigstens ein Oxid, das aus Nickel-, Cobalt-, Eisen-, Yttrium-, Hafnium-, Cer-, Lanthan-, Tantal-, Niob-, Scandium-, Samarium-, Gadolinium-, Dysprosium-, Ytterbium- und Aluminiumoxiden ausgewählt ist, umfasst.

8. Stab nach Anspruch 7, **dadurch gekennzeichnet, dass** wenigstens eine Schicht des Stabs ferner eine Verbindung enthält, die aus Verbindungen des Pyrochlor-Typs, Verbindungen des Granat-Typs und Verbindungen mit Magnetoplumbit-Struktur ausgewählt ist.

9. Stab nach einem der Ansprüche 7 und 8, **dadurch gekennzeichnet, dass** er aus verdichteten Pulvern besteht.

10. Stab nach einem der Ansprüche 7 bis 9, **dadurch gekennzeichnet, dass** er einstückig mit separaten übereinander angeordneten Schichten hergestellt ist.

11. Stab nach einem der Ansprüche 7 bis 9, **dadurch gekennzeichnet, dass** sich seine Zusammensetzung in seiner Längsrichtung schrittweise ändert.

12. Stab nach einem der Ansprüche 7 bis 9, **dadurch gekennzeichnet, dass** er durch Übereinanderanordnen von Rollen unterschiedlicher Zusammensetzungen gebildet ist.

13. Stab nach Anspruch 12, **dadurch gekennzeichnet, dass** die Rollen Reliefs zum gegenseitigen Einrasten aufweisen.

14. Verfahren zur Herstellung eines Stabs nach einem der Ansprüche 7 bis 11, **dadurch gekennzeichnet, dass** es die Schritte umfasst, die darin bestehen:
- eine erste Mischung von Pulvern mit einer ersten Zusammensetzung herzustellen,
- wenigstens eine zweite Mischung von Pulver mit einer zweiten Zusammensetzung, die sich von der ersten unterscheidet, herzustellen,
- die erste Pulvermischung, dann die zweite Pulvermischung in eine Form einzubringen,
- die Pulver in der Form zu verdichten und
- ein Brennen der verdichteten Pulver zu vollziehen.

15. Verfahren nach Anspruch 14, **dadurch gekennzeichnet, dass** unterschiedliche Pulvermischungen, die unterschiedlichen gewünschten Zusammensetzungen der Schichten des Stabs entsprechen, hergestellt werden und die verschiedenen Mischungen nacheinander in die Form eingebracht werden.

16. Verfahren nach Anspruch 14, **dadurch gekennzeichnet, dass** wenigstens zwei Pulvermischungen hergestellt werden, wobei eine ein Zirkonoxidpulver und ein Zirkonoxid-Stabilisatorpulver und die andere ein Zirkonoxidpulver, ein Zirkonoxid-Stabilisatorpulver und ein Pulver mit zusätzlicher Komponente umfasst, eine erste Pulvermischung, dann gleichzeitig die erste Pulvermischung und wenigstens eine zweite Pulvermischung unter schrittweiser Verringerung des Durchsatzes der ersten Mischung und unter schrittweiser Erhöhung des Durchsatzes der zweiten Mischung sowie anschließend die zweite Pulvermischung, nach Unterbrechung des Einbringens der ersten, in die Form eingebracht werden.

17. Verfahren nach Anspruch 16, **dadurch gekennzeichnet, dass** die Pulvermischungen in jeweiligen Spendern gelagert werden und bei ihrem gleichzeitigen Einbringen durch Durchlaufens eines Mischers gemischt werden, um in die Form eingebracht zu werden.

18. Verfahren nach einem der Ansprüche 14 bis 17, **dadurch gekennzeichnet, dass** jede Pulvermischung in flüssigem Medium hergestellt wird.

19. Verfahren nach Anspruch 18, **dadurch gekennzeichnet, dass** dem flüssigen Medium ein organisches Bindemittel zugesetzt wird.

## Claims

1. A method of forming a ceramic coating on a substrate by electron-beam physical vapor deposition, the method comprising the steps of:
- placing in a chamber a composite target in the form of a bar made up of ceramic powder and presenting a composition that is not uniform in the longitudinal direction;
- introducing into the chamber at least one substrate on which a ceramic coating having a composition gradient is to be formed; and
- sweeping a top face of the bar with an electron beam in order to melt the bar material at its top face and form a vapor cloud in the chamber at low pressure,
**characterized in that** :
- a bar is used that presents a plurality of superposed layers of different compositions, the composition within each layer being uniform over the entire cross-section of the bar, and each layer comprising zirconia and at least one oxide selected from the oxides of nickel, cobalt, iron, yttrium, hafnium, cerium, lanthanum, tantalum, niobium, scandium, samarium, gadolinium, dysprosium, ytterbium, and aluminum;
- in such a manner that the ceramic coating formed on the substrate by progressively consuming the bar reflects the variation in the composition of the bar.

2. A method according to claim 1, **characterized in that** a bar is used of composition that varies substantially continuously from one layer to another.

3. A method according to claim 1, **characterized in that** a bar is used of composition that varies stepwise from one layer to another.

4. A method according to claim 3, **characterized in that** the bar is made by superposing disks of different compositions.

5. A method according to any one of claims 1 to 4, for forming a ceramic coating on a substrate constituted by a gas turbine part made of superalloy provided with a thermal barrier metal underlayer.

6. A method according to any one of claims 1 to 5, **characterized in that** a bar is used having at least one layer further including a compound selected from compounds of the pyrochlore type, compounds of the garnet type, and compounds of magnetoplumbite structure.

7. A bar made up of a plurality of different layers for implementing the method according to any one of claims 1 to 6, **characterized in that** each layer is of composition that is uniform over the entire cross-section of the bar and comprises zirconia and at least one oxide selected from the oxides of nickel, cobalt, iron, yttrium, hafnium, cerium, lanthanum, tantalum, niobium, scandium, samarium, gadolinium, dysprosium, ytterbium, and aluminum.

8. A bar according to claim 7, **characterized in that** at least one layer of the bar further includes a compound selected from compounds of the pyrochlore type, compounds of the garnet type, and compounds of magnetoplumbite structure.

9. A bar according to claim 7 or 8, **characterized in that** the bar is made up of compacted powder.

10. A bar according to any one of claims 7 to 9, **characterized in that** the bar is made as a single piece with distinct superposed layers.

11. A bar according to any one of claims 7 to 9, **characterized in that** its composition varies progressively in its longitudinal direction.

12. A bar according to any one of claims 7 to 9, **characterized in that** the bar is constituted by a superposition of disks of different compositions.

13. A bar according to claim 12, **characterized in that** the disks present portions in relief for mutual interfitting.

14. A method of manufacturing a bar according to any one of claims 7 to 11, comprising the steps consisting in:
- preparing a first powder mixture having a first composition;
- preparing at least one second powder mixture having a second composition different from the first;
- introducing the first powder mixture and then the second powder mixture into a mold;
- compacting the powders in the mold; and
- baking the compacted powders.

15. A method according to claim 14, **characterized in that** the various powder mixtures corresponding to different desired compositions for the layers of the bar are prepared and then the various mixtures are introduced in succession into the mold.

16. A method according to claim 14, **characterized in that** at least two powder mixtures are prepared, one comprising zirconia powder and a powder of a zirconia stabilizer, and the other comprising zirconia powder, a powder of a zirconia stabilizer, and a powder of an additional component, the first powder mixture is introduced into the mold and then simultaneously the first powder mixture and at least one second powder mixture are introduced therein with the flow rate of the first mixture being reduced progressively while the flow rate of the second mixture is increased progressively, and subsequently the second powder mixture is introduced after introduction of the first mixture has been stopped.

17. A method according to claim 16, **characterized in that** the powder mixtures are stored in respective dispensers and while they are being introduced simultaneously, they are mixed together by passing through a mixer in order to be introduced into the mold.

18. A method according to any one of claims 14 to 17, **characterized in that** each powder mixture is mixed together in a liquid medium.

19. A method according to claim 18, **characterized in that** an organic binder is added to the liquid medium.
